(19) Europäisches Patentamt / European Patent Office / Office européen des brevets

(11) **EP 4 625 817 A1**

(12) **DEMANDE DE BREVET EUROPEEN**

(43) Date de publication:
**01.10.2025   Bulletin 2025/40**

(21) Numéro de dépôt: **24305465.7**

(22) Date de dépôt: **27.03.2024**

(51) Classification Internationale des Brevets (IPC):
**H03G 3/30** (2006.01)     **H04W 52/52** (2009.01)
**H04B 1/00** (2006.01)     **H04B 1/04** (2006.01)

(52) Classification Coopérative des Brevets (CPC):
**H04B 1/0003; H03G 3/3042; H04B 1/04;
H04W 52/52;** H04B 2001/0416

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**GE KH MA MD TN**

(71) Demandeur: **BULL SAS**
**78340 Les Clayes-Sous-Bois (FR)**

(72) Inventeur: **TENEZE, Bernard**
**13640 La Roque-d'Anthéron (FR)**

(74) Mandataire: **IPAZ**
**Bâtiment Platon**
**Parc Les Algorithmes**
**91190 Saint-Aubin (FR)**

(54) **RADIO LOGICIELLE COMPRENANT UNE GESTION AMÉLIORÉE DE LA PUISSANCE D'ÉMISSION**

(57)   L'invention concerne une radio logicielle (200) comprenant :
- au moins un processeur (104) exécutant un logiciel (102) produisant un signal numérique représentant un flux de données à émettre,
- un convertisseur numérique-analogique, CNA, (106) pour convertir ledit signal numérique en un signal analogique, et
- un amplificateur de puissance radiofréquence (108) pour amplifier la puissance dudit signal analogique ;
ladite radio logicielle (200) comprenant en outre une unité (206,208) d'ajustement de la puissance du signal analogique en fonction :
- de la puissance instantanée du signal analogique en sortie du CNA (106),
- de la puissance instantanée du signal analogique en sortie dudit amplificateur de puissance (108), et
-d'une consigne de gain entre lesdites puissances instantanées.

Elle concerne également un appareil électronique comprenant une telle radio numérique et un procédé de gestion d'une telle radio logicielle.

**FIG. 2**

EP 4 625 817 A1

## Description

La présente invention concerne une radio logicielle comprenant une gestion améliorée de la puissance d'émission. Elle concerne également un appareil comprenant une telle radio logicielle. Elle concerne en outre un procédé de contrôle de la puissance d'émission d'une radio logicielle.

Le domaine de l'invention est le domaine des radios logicielles, également appelées radio SDR (pour « Software Defined Radio » en anglais), et en particulier les radios logicielles émettrices. En particulier, l'invention concerne la gestion de la puissance d'émission d'une radio logicielle.

### État de la technique

Une radio logicielle est équipée d'un amplificateur analogique de puissance. Cet amplificateur permet de produire le signal radio fréquence au niveau de puissance exigé/souhaité pour que la portée radio spécifiée/désirée soit obtenue. Un amplificateur analogique de puissance est un composant électronique dont le gain peut varier en fonction de différents paramètres, tel que la température, la fréquence du signal, etc., ce qui ne permet pas d'assurer un niveau de puissance désiré et stable dans le temps.

Une première solution connue pour répondre à cette problématique et de prévoir une table calibration mais cette solution est complexe et coûteuse car elle nécessite d'établir une table de calibration spécifique à chaque radio logicielle.

Une autre solution consiste ajuster la puissance de l'amplificateur en fonction de la puissance mesurée en sortie dudit amplificateur et d'une consigne de puissance. Cette solution, bien que plus simple que la première, n'est pas utilisable avec des signaux complexes, en particulier des signaux présentant une enveloppe de puissance très variable dans le temps, tels que par exemple des signaux 4G, des signaux 5G, etc.

Un but de la présente invention est de remédier à au moins un des inconvénients précités.

Un autre but de la présente invention est de proposer une radio logicielle comprenant une solution de gestion plus performante de la puissance d'émission, même pour des signaux complexes dont l'enveloppe de puissance est très variable dans le temps.

### Exposé de l'invention

L'invention propose d'atteindre au moins l'un des buts précités par une radio logicielle comprenant :

- au moins un processeur exécutant un logiciel produisant un signal numérique représentant un flux de données à émettre,
- un convertisseur numérique-analogique, CNA, pour convertir ledit signal numérique en un signal analogique, et
- un amplificateur de puissance radiofréquence pour amplifier la puissance dudit signal analogique.

Selon l'invention, ladite radio logicielle comprend en outre une unité d'ajustement de la puissance du signal analogique en fonction :

- de la puissance instantanée du signal analogique en sortie du CNA,
- de la puissance instantanée du signal analogique en sortie dudit amplificateur de puissance, et
- d'une consigne de gain entre lesdites puissances instantanées.

Dans la radio logicielle proposée par la présente invention, l'ajustement de la puissance du signal analogique est réalisé en termes de gain entre la puissance instantanée du signal en sortie de l'amplificateur et la puissance instantanée du signal en sortie du CNA, et d'une consigne de gain entre ce deux puissances instantanées.

A la différence de certaines des solutions de l'état de la technique, l'invention ne propose pas de réaliser un ajustement de puissance basé sur une table de calibration, ce qui est plus simple, plus rapide et moins coûteux à mettre en oeuvre.

A la différence d'autres solutions de l'état de la technique, l'invention ne propose pas de réaliser un ajustement de puissance basé sur une consigne de puissance, ce qui permet une gestion plus performante de la puissance d'émission, même pour des signaux complexes dont l'enveloppe de puissance est très variable dans le temps.

Dans le présent document, par « radio logicielle » ou « Software Defined Radio »,SDR, on entend un émetteur radiofréquence logiciel, ou un émetteur-récepteur radiofréquence logiciel.

Une telle radio logicielle, ou SDR, est utilisée dans de nombreux domaines, et en particulier dans le domaine des communications cellulaires de type 4G ou 5G, sans que l'invention soit limitée à ce domaine.

Suivant des modes de réalisation, la radio logicielle peut en outre comprendre une interface physique entre le processeur et le CNA.

Suivant des modes de réalisation, une telle interface physique peut comprendre, ou peut être, un FPGA (« Field-programmable gate array » ou « Réseau de portes programmables in situ »), ou un ASIC (« Application Specific Integrated Circuit »).

Suivant des modes de réalisation, la radio logicielle peut en comprendre au moins une antenne d'émission, et éventuellement de réception, de signaux radiofréquences, en amont de l'amplificateur de puissance.

Une telle antenne peut être une antenne omnidirectionnelle ou une antenne sectorielle.

La consigne de gain peut être fourni par tout dispositif/organe interne, ou externe, à la radio logicielle.

Suivant des modes de réalisation, la consigne de gain peut être fournie par le processeur de la radio logicielle.

Suivant des modes de réalisation, la consigne de gain peut être une valeur fixe dans le temps.

Avantageusement, la consigne de gain peut être une valeur variable dans le temps, et ajustée en fonction des besoins de la radio logicielle. Par exemple, dans le cas d'une utilisation 4G ou 5G, la consigne de gain peut être ajustée en fonction du nombre d'appareils 4G ou 5G vers lesquels la radio logicielle émet. Suivant encore un autre exemple de réalisation, la consigne de gain peut être ajustée en fonction de la nature du terrain dans lequel la radio logicielle est utilisée. Bien entendu d'autres exemples de réalisation sont possibles sans sortir du cadre de la présente invention.

Suivant des modes de réalisation, l'unité d'ajustement peut être positionnée entre le CNA et l'amplificateur de puissance. En d'autres termes, l'unité d'ajustement peut être configurée pour réaliser un ajustement de la puissance du signal analogique entre le CNA et l'amplificateur de puissance.

Ainsi, l'unité d'ajustement intervient sur le signal analogique fourni par le CNA, en amont de l'amplificateur de puissance. En d'autres termes, l'ajustement de puissance est réalisée en ajustant la puissance du signal avant l'amplificateur de puissance, ce qui est plus simple, moins coûteux et peut être réalisé avec des composants présentant moins d'encombrement.

Dans ces modes de réalisation, l'unité d'ajustement ajuste la puissance du signal analogique avant que celui-ci soit fourni à l'amplificateur de puissance. Par exemple, l'unité d'ajustement peut augmenter, ou diminuer, la puissance du signal analogique, avant que celui-ci soit fourni à l'amplificateur de puissance. En d'autres termes, l'unité d'ajustement permet de compenser, en avance, l'excès ou l'insuffisance d'amplification de puissance réalisée par l'amplificateur de puissance.

L'unité d'ajustement peut être conçue suivant différentes architectures, dès lors qu'elle permet d'ajuster le gain total entre la puissance instantanée du signal en sortie de l'amplificateur de puissance, et la puissance instantanée du signal en sortie du CNA.

Suivant des modes de réalisation, l'unité d'ajustement peut comprendre un module de commande recevant les puissances instantanées et la consigne de gain et calculant une valeur d'ajustement de gain.

Cette valeur d'ajustement de gain peut ensuite être utilisée pour ajuster la puissance instantanée du signal analogique, en particulier en amont de l'amplificateur de puissance.

La valeur d'ajustement de gain peut être utilisée pour commander tout appareil permettant de modifier la puissance instantanée du signal analogique.

Suivant des modes de réalisation, la valeur d'ajustement de gain peut être utilisée pour commander un atténuateur de puissance, recevant le signal analogique, et ajustant la puissance instantanée dudit signal analogique en fonction de ladite valeur d'ajustement.

Suivant des modes de réalisation, le module de commande peut être un composant/organe indépendant dans la radio logicielle selon l'invention.

Suivant des modes de réalisation, le module de commande peut être intégré, partiellement ou totalement, dans le processeur de la radio logicielle ou tout autre composant de la radio logicielle.

Suivant des modes de réalisation, le module de commande peut être, ou comprendre, un composant matériel tel qu'une puce, un processeur, etc.

Suivant des modes de réalisation, le module de commande peut être, ou comprendre, un composant logiciel tel qu'un programme d'ordinateur.

Suivant des modes de réalisation, le module de commande peut être, ou comprendre, une combinaison quelconque d'au moins un composant matériel et d'au moins une composant logiciel.

Suivant des modes réalisation, l'unité d'ajustement peut comprendre un atténuateur de puissance variable, recevant le signal analogique, et modifiant la puissance dudit signal analogique.

De préférence, l'atténuateur peut être disposé en amont de l'amplificateur de puissance, c'est-à-dire entre le CNA et l'amplificateur de puissance. Dans ce cas, l'atténuateur modifie la puissance du signal analogique fourni par le CNA, et de manière générale, la puissance du signal analogique avant l'amplificateur de puissance.

L'atténuateur peut modifier la puissance du signal analogique conformément à une commande déterminée en fonction des données d'entrée de l'unité d'ajustement, à savoir la puissance instantanée du signal analogique en sortie du CNA, la puissance instantanée en sortie dudit amplificateur, et une consigne de gain entre lesdites puissances instantanées. Le cas échéant, la commande peut être déterminée par un module de commande faisant partie de l'unité d'ajustement.

En particulier, l'atténuateur peut être commandée par une consigne relative au gain dudit atténuateur, et en particulier par une consigne relative à la différence entre :

- une valeur consigne de gain, et
- une valeur mesurée du gain ;

entre la puissance instantanée du signal analogique en sortie de l'amplificateur de puissance et la puissance instantanée du signal analogique en sortie du CNA.

La radio logicielle selon l'invention, et en particulier l'unité d'ajustement, peut comprendre un premier capteur pour mesurer la puissance instantanée du signal en sortie du CNA.

Ce premier capteur peut être tout type de capteur pour mesurer la puissance instantanée du signal analogique fourni par le CNA.

Suivant des modes de réalisation, ce premier capteur peut être agencé pour mesurer la puissance instantanée du signal analogique sur une période de temps très courte, en particulier glissante, par exemple de l'ordre de 150 μs, et de manière générale inférieure ou égale à 300 μs, et plus particulièrement inférieure ou égale à 200 μs.

Le premier capteur peut être un capteur indépendant de tout autre composant/organe de la radio logicielle.

Alternativement, le premier capteur peut être intégré, partiellement ou totalement, dans une interface physique se trouvant entre le processeur et le CNA. Une telle interface physique peut être celle décrite plus haut, et peut par exemple être un FPGA ou un ASIC.

La radio logicielle selon l'invention, et en particulier l'unité d'ajustement, peut comprendre un deuxième capteur pour mesurer la puissance instantanée du signal analogique en aval de l'amplificateur de puissance, et en particulier en sortie dudit amplificateur de puissance.

Ce deuxième capteur peut être tout type de capteur pour mesurer la puissance instantanée du signal analogique fourni par l'amplificateur de puissance.

Suivant des modes de réalisation, ce deuxième capteur peut être agencé pour mesurer la puissance instantanée du signal analogique sur une période de temps très courte, en particulier glissante, par exemple de l'ordre de 150 μs, et de manière générale inférieure ou égale à 300 μs, et plus particulièrement inférieure ou égale à 200 μs.

Bien entendu, la radio analogique selon l'invention peut optionnellement comprendre d'autre organe(s)/composant(s) que ceux décrits ici.

Suivant un autre aspect de la même invention, il est proposé un appareil électronique comprenant une radio logicielle selon l'invention.

L'appareil électronique peut être tout type d'appareil, en particulier radiofréquence, prévu pour émettre, ou émettant, un signal radiofréquence, et en particulier un signal radiofréquence représentant des données.

Suivant des exemples de réalisation non limitatifs, l'appareil selon l'invention peut être :

- un émetteur Wifi,
- un émetteur Bluetooth®,
- un émetteur radio numérique terrestre (DAB pour « Digital Audio Broadcasting »),
- un émetteur radio numérique mobile (DMR pour « Digital Mobile radio »),
- etc.

Suivant un autre aspect de la même invention, il est proposé un procédé de gestion d'une radio logicielle comprenant :

- au moins un processeur exécutant un logiciel produisant un signal numérique représentant un flux de données à émettre,
- un convertisseur numérique-analogique, CNA, pour convertir ledit signal numérique en un signal analogique, et
- un amplificateur de puissance radiofréquence pour amplifier la puissance dudit signal analogique fourni par le CNA ;

ledit procédé comprenant une étape d'ajustement de la puissance du signal analogique en fonction :

- de la puissance instantanée du signal analogique en sortie du CNA,
- de la puissance instantanée du signal analogique en sortie dudit amplificateur de puissance, et
- d'une consigne de gain entre lesdites puissances instantanées.

En particulier, suivant des modes de réalisation, l'étape d'ajustement peut comprendre :

- un calcul d'un gain instantané en fonction de la puissance instantanée du signal analogique en sortie du CNA et de la puissance instantanée en sortie de l'amplificateur de puissance ;
- détermination d'un écart de gain entre ledit gain instantané et la consigne de gain ; et
- ajustement, en fonction dudit écart de gain, d'un gain d'un atténuateur variable, en particulier disposé entre le CNA et l'amplificateur de puissance.

Optionnellement, l'ajustement peut être réalisé uniquement si l'écart de gain est supérieur à une valeur seuil prédéterminée. Dans ce cas, la valeur absolue de l'écart de gain peut être comparée audit seuil, et est réalisé si la valeur absolue dudit écart de gain est supérieure audit seuil.

L'ajustement du gain de l'atténuateur peut être réalisé en modifiant le gain dudit atténuateur :

- de la valeur dudit écart de gain, ou
- d'une autre valeur calculée en fonction dudit écart de gain, pour diminuer ledit écart de gain en dessous de la valeur seuil.

Bien entendu d'autres exemples de réalisation sont possibles.

De manière générale, le procédé selon l'invention peut comprendre en termes de fonction, et/ou d'étape, au moins une, ou une combinaison quelconque d'au moins deux, des caractéristiques optionnelles décrites plus haut en référence à la radio logicielle et qui ne sont pas reprises ici en détail par soucis de concision.

## Description des figures et modes de réalisation

D'autres avantages et caractéristiques apparaîtront à l'examen de la description détaillée de modes de réalisation nullement limitatifs, et des dessins annexés sur lesquels :

- la FIGURE 1 est une représentation schématique d'un exemple de réalisation d'une radio logicielle de l'art antérieur ;
- la FIGURE 2 est une représentation schématique d'un exemple de réalisation non limitatif d'une radio logicielle selon l'invention ; et
- la FIGURE 3 est une représentation schématique d'un exemple de réalisation d'un procédé selon l'invention.

Il est bien entendu que les modes de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieure. Cette sélection comprend au moins une caractéristique de préférence fonctionnelle sans détails structurels, ou avec seulement une partie des détails structurels si c'est cette partie qui est uniquement suffisante pour conférer un avantage technique ou pour différencier l'invention par rapport à l'état de la technique antérieure.

En particulier toutes les variantes et tous les modes de réalisation décrits sont combinables entre eux si rien ne s'oppose à cette combinaison sur le plan technique.

Sur les figures et dans la suite de la description, les éléments communs à plusieurs figures conservent la même référence.

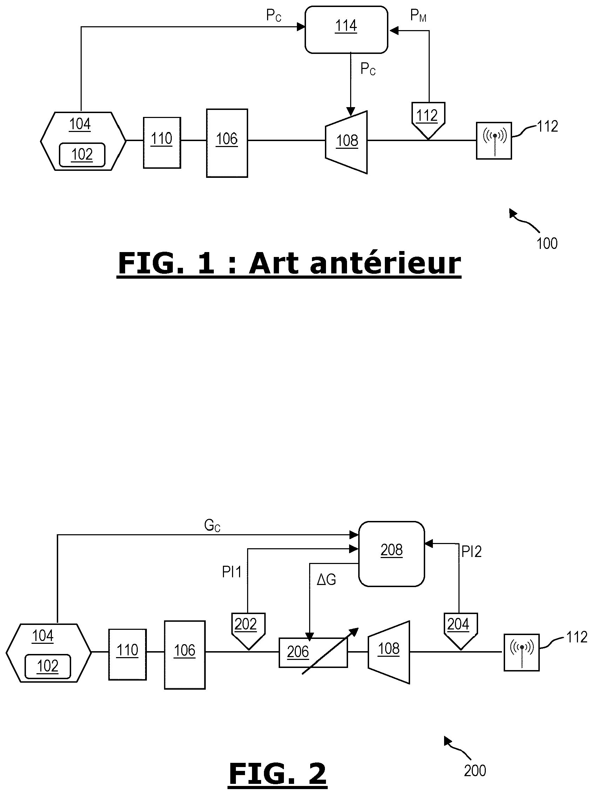

La FIGURE 1 est une représentation schématique d'une radio logicielle de l'art antérieur.

La radio logicielle 100, représentée sur la FIGURE 1, comprend un logiciel 102, ou un programme d'ordinateur, produisant des données numériques, ou un flux de données numériques, à émettre par la radio logicielle. Le logiciel peut être de tout type et les données à transmettre peuvent être de tout type. Par exemple, les données numériques peuvent être des données de communication entre un premier appareil intégrant la radio logicielle et un autre appareil comportant un récepteur radio fréquence. Les données peuvent être des données représentant de la musique, une vidéo, des données représentant le résultat d'un calcul, des données représentant le résultat de mesures d'une grandeur physique, etc.

De manière classique, le logiciel 102 est exécuté dans au moins un calculateur ou au moins un processeur, CPU, 104. Un seul CPU 104 est représenté sur la FIGURE 1, sans perte de généralité. La radio logicielle peut comprendre plusieurs CPUs.

La radio logicielle 100 comprend en outre un convertisseur numérique-analogique, CNA, 106 pour transformer les données numériques produites dans le CPU 104, en un signal analogique.

Le signal analogique généré par le CNA 106 est ensuite transmis à un amplificateur de puissance radiofréquence 108. Ce dernier augmente la puissance du signal analogique en vue de son émission dans les airs au travers d'une antenne d'émission. L'amplificateur de puissance 108 est un composant classiquement utilisé dans les radios logicielles.

De manière optionnelle, la radio logicielle 100 comprend, entre le CPU 104 et le CNA 106, un composant physique 110, réalisant l'interface physique entre le CPU 104 et le CNA 106. De manière classique, le composant 110 peut être un composant électronique programmable. Suivant des exemples non limitatifs, le composant 110 peut être un FPGA, ou un ASIC. Le composant 110 a pour rôle de faire l'interface être le CPU et le CNA et de transmettre le signal numérique produit dans le CPU vers le CNA en vue de sa conversation en un signal analogique.

Optionnellement, la radio logicielle 100 peut comprendre une antenne d'émission 112, reliée directement ou indirectement à l'amplificateur de puissance 108, pour émettre dans les airs le signal analogique amplifié fourni par l'amplificateur de puissance 108.

La radio logicielle 100 de la FIGURE 1 comprend en outre un capteur de puissance 112 pour mesurer la puissance moyenne, notée $P_m$ dans la suite, du signal analogique amplifié fourni par l'amplificateur de puissance 108. Ce capteur 112 mesure la puissance moyenne $P_m$ du signal fourni par l'amplificateur de puissance 108. La valeur de $P_m$ mesurée par le capteur mesure 112 est fournie à une unité 114 d'ajustement de la puissance.

L'unité d'ajustement 114 reçoit d'une part la valeur de la puissance moyenne $P_m$ mesurée par le capteur 112. D'autre part, l'unité d'ajustement 114 reçoit une valeur consigne de puissance moyenne, notée Pc, par exemple de la part du CPU 104.

En fonction de la valeur mesurée $P_M$ et de la valeur consigne Pc, l'unité d'ajustement 114 ajuste le gain de l'amplificateur 108, avec une commande de gain, de sorte à satisfaire la valeur de consigne Pc. Par exemple :

- si $P_M < P_C$ l'unité d'ajustement 114 augmente le gain de l'amplificateur de puissance 108 ;
- si $P_M > P_C$ l'unité d'ajustement 114 diminue le gain de l'amplificateur de puissance 108 ;
- si $P_M = P_C$ l'unité d'ajustement 114 ne change pas le gain de l'amplificateur de puissance 108.

Cette solution d'ajustement de puissance bien que simple à mettre en oeuvre n'est pas utilisable avec des signaux complexes, en particulier des signaux présentant une enveloppe de puissance très variable dans le temps, tels que par exemple des signaux 4G, des signaux 5G, etc. La présente invention a pour but de répondre à cette problématique.

La FIGURE 2 est une représentation schématique d'un exemple de réalisation non limitatif d'une radio logicielle selon l'invention.

La radio logicielle 200, représentée sur la FIGURE 2, comprend tous les éléments de la radio logicielle 100 de la FIGURE 1, sauf le capteur 112 et l'unité d'ajustement 114.

A la différence de la radio logicielle de la FIGURE 1, la radio logicielle 200 comprend un premier capteur 202 pour mesurer la puissance instantanée, notée PI1, du signal analogique sortant du CNA 106.

Dans l'exemple représenté sur la FIGURE 2, le premier capteur 202 est disposé juste après le CNA 106.

Le premier capteur 202 peut être tout type de capteur. En particulier, le premier capteur 202 peut être agencé pour mesurer la puissance instantanée PI1 du signal analogique sortant du CNA 106 sur une période de temps très courte, en particulier glissante, par exemple de l'ordre de 150 μs.

La radio logicielle 200 comprend en outre un deuxième capteur 204 pour mesurer la puissance instantanée, notée PI2, du signal analogique sortant de l'amplificateur de puissance 108, et plus généralement du signal analogique que la radio logicielle fournit à l'antenne 112 pour émission.

Dans l'exemple représenté sur la FIGURE 2, le deuxième capteur 204 est disposé juste après l'amplificateur de puissance 108.

Le deuxième capteur 204 peut être tout type de capteur. En particulier, le premier capteur 204 peut être agencé pour mesurer la puissance instantanée du signal analogique sortant de l'amplificateur de puissance 108 sur une période de temps très courte, en particulier glissante, par exemple de l'ordre de 150 μs.

La radio logicielle 200 comprend en outre un atténuateur de puissance 206, variable, commandable, pour modifier la puissance du signal analogique. Dans l'exemple représenté, l'atténuateur de puissance 206 est disposé entre le CNA 106, et en particulier le premier capteur 202, et l'amplificateur de puissance 108. Ainsi, l'atténuateur de puissance 206 est agencé pour modifier la puissance du signal analogique fourni par le CNA 106, avant que ledit signal soit fourni à l'amplificateur de puissance 108.

La radio logicielle 200 comprend en outre un module de commande 208 pour commander l'atténuateur de puissance 206 en fonction de plusieurs valeurs qui lui sont fournies, à savoir :

- la valeur de la puissance instantanée PI1 du signal analogique en sortie du CNA 106 et mesuré par le premier capteur 202 ;
- la valeur de la puissance instantanée PI2 du signal analogique en sortie de l'amplificateur de puissance et mesuré par le deuxième capteur 204 ; et
- une valeur consigne de gain, noté $G_C$.

Plus particulièrement, le module de contrôle 208 est configuré pour calculer une valeur, noté $G_m$, de gain instantanée en fonction des valeurs PI1 et PI2.

En particulier, la valeur de gain instantanée $G_m$ est calculée selon la relation :

$$G_m = PI2/PI1$$

Le module de commande 208 est en outre configuré pour comparer la valeur $G_m$ à la valeur consigne de gain $G_c$ et ajuste le gain de l'atténuateur de puissance 206 pour atteindre la valeur consigne $G_c$ entre la puissance du signal fourni par l'amplificateur de puissance 108 et la puissance du signal fourni par le CNA.

Par exemple, le module de commande 208 fournit une commande de variation de gain, sous la forme d'une valeur de variation de gain, notée ΔG, calculée selon la relation suivante :

$$\Delta G = G_C - G_m$$

Optionnellement, le module de commande 208 peut d'abord comparer la valeur absolue de ΔG à un seuil prédéterminé, noté S.

Si |ΔG|<S, aucune modification de gain n'est commandée : on considère dans ce cas que la puissance du signal analogique à émettre est acceptable et ne nécessite pas d'ajustement.

Dans le cas contraire, la valeur de ΔG est communiquée à l'atténuateur de puissance 206 pour ajustement du gain global entre la puissance du signal en sortie de l'amplificateur 108 et la puissance du signal en sortie du CNA 106.

Sur la FIGURE 2, chaque composant/organe de la radio logicielle est représenté de manière individuelle et indépendante des autres organes/composants.

Suivant des variantes non représentées, le premier capteur 202 peut être intégré dans l'interface physique 110.

Alternativement, ou en plus, le module de commande 208 peut être intégré partiellement ou totalement dans le CPU 104.

Sur la FIGURE 2, le gain de consigne est fourni au module de commande 208 par le CPU 104. Bien entendu, ce gain de consigne peut être fourni par un autre organe/composant de la radio logicielle, ou par un organe/composant externe à la radio logicielle.

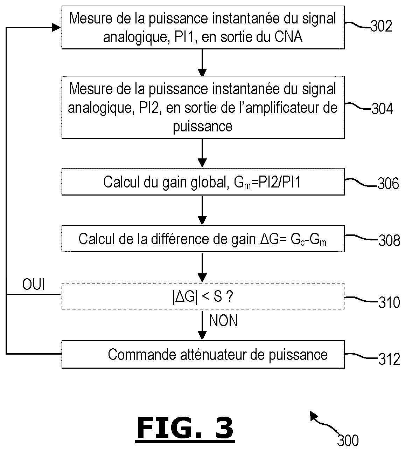

La FIGURE 3 est une représentation schématique d'un exemple de réalisation non limitatif d'un procédé selon l'invention.

Le procédé 300, représenté sur la FIGURE 3, peut être mis en oeuvre dans une radio logicielle selon l'invention, et en particulier dans la radio logicielle 200 de la FIGURE 2.

Le procédé 300 comprend une étape 302 de mesure de la puissance instantanée, notée PI1, du signal analogique en sortie du CNA de la radio logicielle.

Lors d'une étape 304, la puissance instantanée, notée PI2, du signal analogique en sortie de l'amplificateur de puissance de la radio logicielle est mesurée. Les étapes 302 et 304 peuvent être réalisées en même temps, ou à tour de rôle.

Puis, lors d'une étape 306, le gain instantané $G_m$ est calculé, par exemple avec la relation suivante :

$$G_m = PI2/PI1$$

Lors d'une étape 308, un écart de gain instantané $\Delta G$ est calculé, par exemple en utilisant la relation suivante :

$$\Delta G = G_c - G_m$$

Lors d'une étape 310, optionnelle, la valeur absolue de l'écart de gain, $|\Delta G|$ est comparée à un seuil prédéfini, noté S. Si la valeur absolue de l'écart de gain $|\Delta G|$ est inférieure au seuil S, alors aucun ajustement de puissance n'est réalisé. Dans le cas contraire, le procédé réalise un ajustement de puissance pour modifier la puissance du signal analogique.

Lors d'une étape, une commande de modification de gain est envoyée à l'atténuateur de puissance. Cette commande peut comprendre la valeur de l'écart de gain $\Delta G$ à corriger. Alternativement, cette commande peut comprendre une valeur permettant de ramener l'écart de gain à une valeur inférieure au seuil S.

Le procédé 300 peut être réitéré en continue, ou à une fréquence prédéterminée.

Le procédé 300 peut comprendre d'autres étapes que celles décrites ici en référence à la FIGURE 3.

De manière générale, l'invention n'est pas limitée aux exemples qui viennent d'être décrits.

## Revendications

**1.** Radio logicielle (200) comprenant :

- au moins un processeur (104) exécutant un logiciel (102) produisant un signal numérique représentant un flux de données à émettre,
- un convertisseur numérique-analogique, CNA, (106) pour convertir ledit signal numérique en un signal analogique, et
- un amplificateur de puissance radiofréquence (108) pour amplifier la puissance dudit signal analogique ;

ladite radio logicielle (200;300) comprenant en outre une unité (206,208) d'ajustement de la puissance du signal analogique en fonction :

- de la puissance instantanée du signal analogique en sortie du CNA (106),
- de la puissance instantanée du signal analogique en sortie dudit amplificateur de puissance (108), et

- d'une consigne de gain entre lesdites puissances instantanées.

**2.** Radio (200) selon la revendication précédente, **caractérisée en ce que** la consigne de gain est fournie par le processeur (104).

**3.** Radio (200) selon l'une quelconque des revendications précédentes, **caractérisée en ce que** l'unité d'ajustement est positionnée entre le CNA (106) et l'amplificateur de puissance (108).

**4.** Radio (200) selon l'une quelconque des revendications précédentes, **caractérisée en ce que** l'unité d'ajustement comprend un module de commande (208) recevant les puissances instantanées et la consigne de gain et calculant une valeur d'ajustement de gain.

**5.** Radio (200) selon la revendication précédentes, **caractérisée en ce que** le module de commande (208) est intégré partiellement ou totalement dans le processeur (104).

**6.** Radio (200) selon l'une quelconque des revendications précédentes, **caractérisée en ce que** l'unité d'ajustement comprend un atténuateur de puissance (206) variable, recevant le signal analogique, et modifiant la puissance dudit signal analogique.

**7.** Radio (200) selon l'une quelconque des revendications précédentes, **caractérisée en ce qu'**elle comprend un premier capteur (202) pour mesurer la puissance instantanée (PI1) du signal en sortie du CNA (106).

**8.** Radio selon la revendication précédente, **caractérisée en ce qu'**elle comprend une interface physique (110) entre le processeur (104) et le CNA (106), le premier capteur de puissance instantanée (202) étant intégré, partiellement ou totalement, dans ladite interface physique (110).

**9.** Radio (200) selon l'une quelconque des revendications précédentes, **caractérisée en ce qu'**elle comprend un deuxième capteur (204) pour mesurer la puissance instantanée (PI2) du signal analogique en aval de l'amplificateur de puissance (108).

**10.** Appareil électronique comprenant une radio logicielle (200) selon l'une quelconque des revendications précédentes.

**11.** Appareil selon la revendication précédente, **caractérisée en ce qu'**il s'agit d'un émetteur Wifi, d'un émetteur Bluetooth®, un émetteur radio numérique terrestre (DAB pour « Digital Audio Broadcasting »), un émetteur radio numérique mobile (DMR pour

**EP 4 625 817 A1**

« Digital Mobile radio »).

**12.** Procédé (300) de gestion d'une radio logicielle (200) comprenant :

- au moins un processeur (104) exécutant un logiciel (102) produisant un signal numérique représentant un flux de données à émettre,
- un convertisseur numérique-analogique, CNA, (106) pour convertir ledit signal numérique en un signal analogique, et
- un amplificateur de puissance radiofréquence (108) pour amplifier la puissance dudit signal analogique fourni par le CNA (106) ;

ledit procédé (300) comprenant une étape (306-312) d'ajustement de la puissance du signal analogique (108) en fonction :

- de la puissance instantanée du signal analogique en sortie du CNA (106),
- de la puissance instantanée du signal analogique en sortie dudit amplificateur de puissance (108), et
- d'une consigne de gain entre lesdites puissances instantanées.

**13.** Procédé (300) selon la revendication précédente, **caractérisé en ce que** l'étape d'ajustement comprend :

- un calcul (306) d'un gain instantané en fonction de la puissance instantanée (PI1) du signal analogique en sortie du CNA (106) et de la puissance instantanée (PI2) du signal analogique en sortie de l'amplificateur de puissance (108) ;
- détermination (308) d'un écart de gain ($\Delta G$) entre ledit gain instantané et la consigne de gain ; et
- ajustement (312), en fonction dudit écart de gain ($\Delta G$), d'un gain d'un atténuateur variable (206), en particulier disposé entre le CNA (106) et l'amplificateur de puissance.

$P_C$ ⟶ 114 ⟵ $P_M$

$P_C$

104

102

110 106 108 112 ((( ))) ⌐112

100

# FIG. 1 : Art antérieur

$G_C$ ⟶ 208 ⟵ PI2

PI1

ΔG

104

102

110 106 202 206 108 204 ((( ))) ⌐112

200

# FIG. 2

Mesure de la puissance instantanée du signal analogique, PI1, en sortie du CNA —302

Mesure de la puissance instantanée du signal analogique, PI2, en sortie de l'amplificateur de puissance —304

Calcul du gain global, $G_m = PI2/PI1$ —306

Calcul de la différence de gain $\Delta G = G_c - G_m$ —308

OUI

$|\Delta G| < S$ ? —310

NON

Commande atténuateur de puissance —312

# FIG. 3

300

Europäisches
Patentamt

European
Patent Office

Office européen
des brevets

# RAPPORT DE RECHERCHE EUROPEENNE

**Numéro de la demande**

EP 24 30 5465

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2004/083409 A1 (ROZENBLIT DMITRIY [US] ET AL) 29 avril 2004 (2004-04-29) * alinéa [0002] - alinéa [0013] * * alinéa [0022] - alinéa [0050] * * figures 1, 2 * ----- | 1-13 | INV. H03G3/30 H04W52/52 H04B1/00 H04B1/04 |
| X | US 2012/149423 A1 (BURDENSKI RALF [DE] ET AL) 14 juin 2012 (2012-06-14) * alinéa [0001] - alinéa [0017] * * alinéa [0046] - alinéa [0082] * * figures 1-7 * ----- | 1-13 | |
| A | EP 1 276 232 A1 (TTP COMMUNICATIONS LTD [GB]) 15 janvier 2003 (2003-01-15) * le document en entier * ----- | 1-13 | |

**DOMAINES TECHNIQUES RECHERCHES (IPC)**

H03G
H04W
H04B

Le présent rapport a été établi pour toutes les revendications

| Lieu de la recherche | Date d'achèvement de la recherche | Examinateur |
|---|---|---|
| Munich | 14 août 2024 | Patrovsky, Andreas |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

................................................................
& : membre de la même famille, document correspondant

EPO FORM 1503 03.82 (P04C02)

**EP 4 625 817 A1**

## ANNEXE AU RAPPORT DE RECHERCHE EUROPEENNE
## RELATIF A LA DEMANDE DE BREVET EUROPEEN NO.

EP 24 30 5465

14-08-2024

| Document brevet cité au rapport de recherche | Date de publication | Membre(s) de la famille de brevet(s) | Date de publication |
|---|---|---|---|
| US 2004083409 A1 | 29-04-2004 | AUCUN | |
| US 2012149423 A1 | 14-06-2012 | EP 2649726 A1 | 16-10-2013 |
| | | US 2012149423 A1 | 14-06-2012 |
| | | WO 2012080161 A1 | 21-06-2012 |
| EP 1276232 A1 | 15-01-2003 | AT E395746 T1 | 15-05-2008 |
| | | EP 1276232 A1 | 15-01-2003 |
| | | ES 2305034 T3 | 01-11-2008 |

EPO FORM P0460